# EUROPEAN PATENT APPLICATION

(11) **EP 3 316 286 A1**
(43) Date of publication of application: **02.05.2018**
(21) Application number: 17199627.5
(22) Date of filing: 02.11.2017
(51) Int. Cl.: H01L 21/8234, H01L 27/088

(54) **DUMMY GATE STRUCTURES AND MANUFACTURING METHOD THEREOF**

(30) Priority: 31.10.2016 CN 201610927382
(71) Applicant: Semiconductor Manufacturing International Corporation (Shanghai), Shanghai 201203 (CN); Semiconductor Manufacturing International Corporation (Beijing), Beijing 100176 (CN)
(72) Inventor: ZHOU, Fei, Shanghai, 201203 (CN)
(74) Representative: Klunker IP Patentanwälte PartG mbB

(57) **Abstract**

A semiconductor device includes a semiconductor substrate (30), a fin (41, 42) protruding from the semiconductor substrate, a trench on opposite sides of the fin, a first insulator layer (31) partially filling the trench, a second insulator layer (32) on the fin, a plurality of dummy gate structures for the fin and including a first dummy gate structure (401, 404) on the first insulator layer (31) and a second dummy gate structure (402, 405) on the second insulator layer (32), the first dummy gate structure adjacent to a portion of the second insulator layer (32) on a side surface of the one or more fins, a spacer (37) on side surfaces of the dummy gate structures, and a source or drain (61, 63) in the fin and between the dummy gate structures. The fin protrudes from the first insulator layer. The first and second dummy gate structures are spaced apart from each other. The semiconductor device has improved insulation between active regions of different devices.

## Description

### CROSS-REFERENCES TO RELATED APPLICATIONS

The present application claims priority to Chinese patent application No. 201610927382.1, filed with the State Intellectual Property Office of People's Republic of China on October 31,2016.

### TECHNICAL FIELDINVENTION

The present invention relates to integrated semiconductor devices, and more particularly to a fin-type field effect transistor device and manufacturing method thereof.

### BACKGROUND

Fin field effect transistor (FinFET) devices can improve the performance of a semiconductor device, lower the supply voltage level, and significantly reduce the short channel effect. However, FinFET devices still face many problems in current manufacturing processes. For example, the source and drain layers are raised in NMOS and PMOS transistor devices to advantageously increase the stress in the channel region and reduce the contact resistance. However, the source and drain layers formed by an epitaxial process on the fin may have an irregular morphology, which affects the uniformity of device performance.

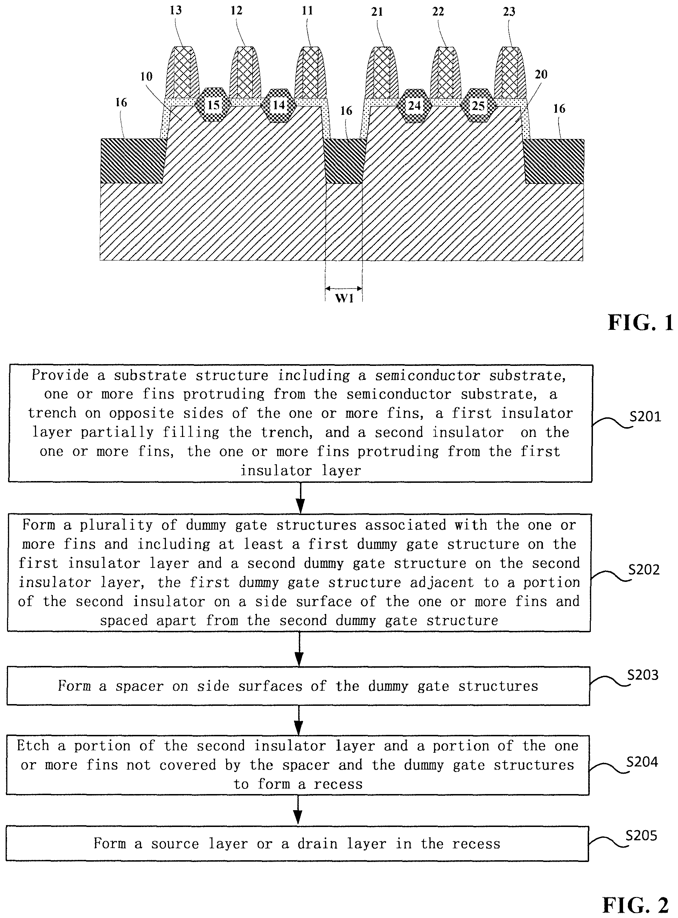

The prior art approach for solving the irregular morphology issues of the source and drain layers is to form a dummy gate on the edge of the Fin active region. FIG. 1 is a cross-sectional view illustrating a structure of a semiconductor device that can be used to illustrate the problems. As shown in FIG. 1, the structure includes a first fin 10 and a second fin 20, dummy gates 11, 12, and 13 on first fin 10, and dummy gates 21, 22, and 23 on second fin 20. A source 14 is formed between dummy gates 21 and 22, and a drain 15 is formed between dummy gates 21 and 22. A source 24 is formed between dummy gates 21 and 22, and a drain 25 is formed between dummy gates 22 and 23. Since dummy gates 11 and 13 are formed on the distal ends of the first fin, and dummy gates 21 and 23 are formed on the distal ends of the second fin, the formed source and drain have a relatively regular morphology.

Referring to FIG. 1, a trench is formed on opposite sides of the fin and partially filled with an insulation layer 16. The trench between first fin 10 and second fin 20 has a width W1. The insulation between the two fins in the prior art is relatively poor.

### BRIEF SUMMARY OF THE INVENTION

It is an object of the present invention to propose a semiconductor device and a method for manufacturing the same which address the above-described problems, in particular a method which achieves an improved insulation between two fins and correspondingly a semiconductor device having an improved isolation between two fins.

According to a first aspect of the present invention, a method for manufacturing a semiconductor device includes providing a semiconductor structure having a semiconductor substrate, one or more fins protruding from the semiconductor substrate, a trench on opposite sides of the one or more fins, a first insulator layer partially filling the trench, and a second insulator layer on the one or more fins, the one or more fins protruding from the first insulator layer. The method further includes forming a plurality of dummy gate structures associated with the one or more fins, forming a spacer on side surfaces of the dummy gate structures, etching a portion of the second insulator layer and a portion of the one or more fins not covered by the spacer and the plurality of dummy gate structures to form a recess, and forming a source or a drain in the recess. The plurality of dummy gate structures include at least a first dummy gate structure on the first insulator layer and a second dummy gate structure on the second insulator layer, the first and second dummy gate structures being spaced apart from each other, the first dummy gate structure adjacent to a portion of the second insulator layer on a side surface of the one or more fins;

Preferably, a ratio of a width of the trench to a longitudinal length of the one or more fins is in the range between 0.5 and 0.7. In one embodiment, the width of the trench is in the range between 80 nm and 130 nm.

Preferably, the plurality of dummy gate structures further include a third dummy gate structure spaced apart from the second dummy gate structure, the first and third dummy gate structures being disposed on opposite sides of the second dummy gate structure, and the third dummy gate structure disposed on a portion of the second insulator layer on a distal end of the one or more fins, or the third dummy gate structure disposed on the first insulator layer and adjacent to a portion of the second insulator layer on a side surface of the one or more fins.

Preferably, the recess includes a first recess between the first dummy gate structure and the second dummy gate structure, and a second recess between the second dummy gate structure and the third dummy gate structure. The method further includes forming the source in the first recess and the drain in the second recess.

Preferably, the one or more fins include a first fin and a second fin spaced apart from each other by the trench; the first, second, and third dummy gate structures being associated with the first fin. The plurality of dummy gate structures further include fourth, fifth, and sixth dummy gate structures associated with the second fin, wherein the fourth and sixth dummy gate structures are disposed on opposite sides of the fifth dummy gate structure.

Preferably, the first dummy gate structure is disposed on the first insulator layer in the trench between the first fin and the second fin and adjacent to a portion of the second insulator layer on a side surface of the first fin; the fourth dummy gate structure is disposed on the first insulator layer in the trench between the first fin and the second fin and adjacent to a portion of the second insulator layer on a side surface of the second fin; and the first and fourth dummy gate structures are spaced apart from each other.

Preferably, the first dummy gate structure is disposed on the first insulator layer in the trench between the first fin and the second fin and adjacent to a portion of the second insulator layer on a side surface of the first fin; the fourth dummy gate structure is disposed on a portion of the second insulator layer on a distal end of the second fin; and the first and fourth dummy gate structures are spaced apart from each other.

Preferably, each of the dummy gate structures includes a dummy gate on the first insulator layer or on the second insulator layer, and a hardmask layer on the dummy gate.

Preferably, the method further includes forming an interlayer dielectric layer on the semiconductor structure after forming the source or the drain; planarizing the interlayer dielectric layer to expose an upper surface of the hardmask layer; removing the hardmask layer, the dummy gate structures, and a portion of the second insulator layer to form an opening; and forming a gate structure in the opening, the gate structure including a gate insulator layer on the one or more fins and a gate on the gate insulator layer.

A second aspect of the present invention provides a semiconductor device. The semiconductor device includes a semiconductor substrate, one or more fins protruding from the semiconductor substrate, a trench on opposite sides of the one or more fins, a first insulator layer partially filling the trench, the one or more fins protruding from the first insulator layer, a second insulator layer on the one or more fins, a plurality of dummy gate structures associated with the one or more fins, a spacer on side surfaces of the dummy gate structures, and a source or drain in the one or more fins and between the dummy gate structures. In one embodiment, the plurality of dummy gate structures include at least a first dummy gate structure on the first insulator layer and a second dummy gate structure on the second insulator layer. The first and second dummy gate structures are spaced apart from each other, and the first dummy gate structure is adjacent to (abuts) a portion of the second insulator layer on a side surface of the one or more fins;

Preferably, a ratio of a width of the trench to a longitudinal length of the one or more fins is in the range between 0.5 and 0.7. In one embodiment, the width of the trench is in the range between 80 nm and 130 nm.

Preferably, the plurality of dummy gate structures further include a third dummy gate structure spaced apart from the second dummy gate structure, the first and third dummy gate structures being disposed on opposite sides of the second dummy gate structure, and the third dummy gate structure disposed on a portion of the second insulator layer on a distal end of the one or more fins, or the third dummy gate structure disposed on the first insulator layer and adjacent to a portion of the second insulator layer on a side surface of the one or more fins.

Preferably, the one or more fins include a first fin and a second fin spaced apart from each other by the trench; the first, second, and third dummy gate structures being associated with the first fin. The plurality of dummy gate structures further include fourth, fifth, and sixth dummy gate structures that are associated with the second fin, and the fourth and sixth dummy gate structures are disposed on opposite sides of the fifth dummy gate structure.

Preferably, the first dummy gate structure is disposed on the first insulator layer in the trench between the first fin and the second fin and adjacent to a portion of the second insulator layer on a side surface of the first fin; the fourth dummy gate structure is disposed on the first insulator layer in the trench between the first fin and the second fin and adjacent to a portion of the second insulator layer on a side surface of the second fin; and the first and fourth dummy gate structures are spaced apart from each other.

Preferably, the first dummy gate structure is disposed on the first insulator layer in the trench between the first fin and the second fin and adjacent to a portion of the second insulator layer on a side surface of the first fin; the fourth dummy gate structure is disposed on a portion of the second insulator layer on a distal end of the second fin; and the first and fourth dummy gate structures are spaced apart from each other.

Preferably, each of the dummy gate structures includes a dummy gate on the first insulator layer or on the second insulator layer, and a hardmask layer on the dummy gate.

Preferably, the semiconductor device further includes a recess in the one or more fins between the plurality of dummy gate structures. The source or drain is disposed in the recess.

A semiconductor device according to the second aspect of the present invention may be obtained by a method according to the first aspect.

The following detailed description together with the accompanying drawings will provide a better understanding of the nature and advantages of the present invention.

### BRIEF DESCRIPTION OF THE DRAWINGS

The accompanying drawings, which form a port of the description, illustrate embodiments of the invention, and together with the following description, serve to explain the principles of the invention.
FIG. 1 is a cross-sectional view illustrating a structure of a semiconductor device according to the prior art.
FIG. 2 is a flowchart of a method for manufacturing a semiconductor device according to an embodiment of the present invention.
FIG. 3 is a cross-sectional view illustrating a structure in the manufacturing method of a semiconductor device including a semiconductor substrate, fins one the substrate, a trench between the fins and partially filled with a first insulator layer, and a second insulator layer on the fins according to one embodiment of the present invention.
FIG. 4 is a cross-sectional view illustrating a structure in the manufacturing method of a semiconductor device having a dummy gate material layer according to one embodiment of the present invention.
FIG. 5 is a cross-sectional view illustrating a structure in the manufacturing method of a semiconductor device having multiple dummy gate structures according to one embodiment of the present invention.
FIG. 6 is a cross-sectional view illustrating a structure in the manufacturing method of a semiconductor device having a spacer on side surfaces of the dummy gate structures according to one embodiment of the present invention.
FIG. 7 is a cross-sectional view illustrating a structure in the manufacturing method of a semiconductor device having a recess between the dummy gate structures according to one embodiment of the present invention.
FIG. 8 is a cross-sectional view illustrating a structure in the manufacturing method of a semiconductor device having source and drain in the recess according to one embodiment of the present invention.
FIG. 9 is a cross-sectional view illustrating a structure in the manufacturing method of a semiconductor device having an interlayer dielectric layer according to one embodiment of the present invention.
FIG. 10 is a cross-sectional view illustrating a structure in the manufacturing method of a semiconductor device after planarizing the interlayer dielectric layer according to one embodiment of the present invention.
FIG. 11 is a cross-sectional view illustrating a structure in the manufacturing method of a semiconductor device having the according to one embodiment of the present invention.

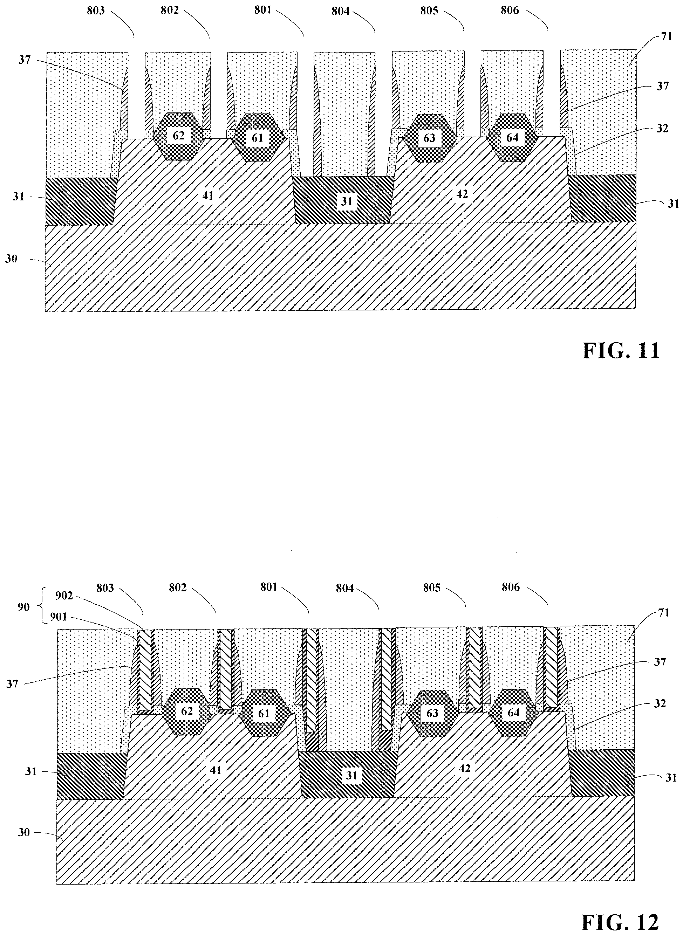

FIG. 11 is a cross-sectional view illustrating a structure in the manufacturing method of a semiconductor device having the dummy gate structures removed according to one embodiment of the present invention.
FIG. 12 is a cross-sectional view illustrating a structure in the manufacturing method of a semiconductor device having gate structures according to one embodiment of the present invention.

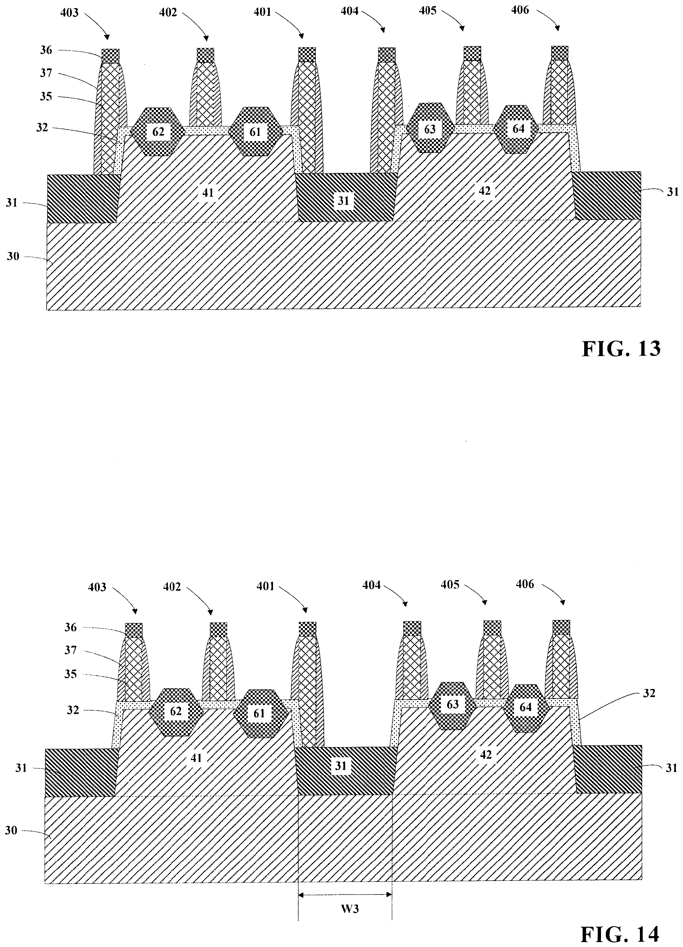

FIG. 13 is a cross-sectional view illustrating a structure in the manufacturing method of a semiconductor device having multiple having multiple dummy gate structures according to another embodiment of the present invention.
FIG. 14 is a cross-sectional view illustrating a structure in the manufacturing method of a semiconductor device having multiple having multiple dummy gate structures according to further embodiments of the present invention.

### DETAILED DESCRIPTION OF THE INVENTION

Embodiments of the present invention now will be described more fully hereinafter with reference to the accompanying drawings. The invention may, however, be embodied in many different forms and should not be construed as limited to the embodiments set forth herein. Rather, these embodiments are provided so that this invention will be thorough and complete, and will fully convey the invention to those skilled in the art. The features may not be drawn to scale, some details may be exaggerated relative to other elements for clarity. Like numbers refer to like elements throughout.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "lateral" or "vertical" may be used herein to describe a relationship of one element, layer or region to another element, layer or region as illustrated in the figures. It will be understood that these terms are intended to encompass different orientations of the device in addition to the orientation depicted in the figures.

The terminology used herein is for the purpose of describing particular embodiments only and is not intended to be limiting of the invention. As used herein, the singular forms "a", "an", and "the" are intended to include the plural forms as well, unless the context clearly indicates otherwise. It will be further understood that the terms "comprises", "comprising", "includes", and/or "including" when used herein, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-sectional illustrations that are schematic illustrations of idealized embodiments (and intermediate structures) of the invention. The thickness of layers and regions in the drawings may be enlarged relative to other layers and regions for clarity. Additionally, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a discrete change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the invention.

Embodiments of the present invention now will be described more fully hereinafter with reference to the accompanying drawings, in which embodiments of the invention are shown. This invention may, however, be embodied in many different forms and should not be construed as limited to the embodiments set forth herein.

It is noted that the reference numerals and letters denote similar items in the accompanying drawings. Thus, once an item is defined or illustrated in a drawing, it will not be further described in subsequent drawings.

FIG. 2 is a flowchart illustrating a method of manufacturing a semiconductor device according to one embodiment of the present invention. The method may include the following process steps:
S201: providing a semiconductor structure including a semiconductor substrate, one or more fins protruding from the semiconductor substrate, a trench on opposite sides of the fins, a first insulator layer partially filling the trench, wherein the fins protrude from the first insulator layer, and a second insulator layer overlying the fins. In one embodiment, the ratio of the width of the trench to the longitudinal length of the fins is in the range between 0.5 and 0.7. It should be noted that, as used herein, the longitudinal length of the fins refers to the length of the fins extending in the longitudinal direction. In one embodiment, the width of the trench may be in the range between 80 nm and 130 nm, e.g., 100 nm, or 120 nm.
S202: forming a plurality of dummy gate structures for the fins. The dummy gate structure may include at least a first dummy gate structure on the first insulator layer and a second dummy gate structure on the second insulator layer. The first and second dummy gate structures are spaced apart from each other. The first dummy gate structure abuts a portion of the second insulator layer on the edge of the fin. In an example embodiment, the dummy gate structure may include a dummy gate (e.g., polysilicon) disposed on the first insulator layer or on the second insulator layer, and a hardmask layer (e.g., silicon nitride) on the dummy gate.
S203: forming a spacer on side surfaces of the dummy gate structures.
S204: removing (e.g., using an etch process) a portion of the second insulator layer and a portion of the fins not covered by the spacer and by the dummy gate structures to form a recess.
S205: forming a source layer or a drain layer in the recess.

In the above-described embodiment, in the process of forming the semiconductor structure, a relatively wide trench may be formed, and in the process of forming the dummy gate structures, the dummy gate structures may be formed on the first insulator layer in the trench adjacent to the side edges of the fins. Since the width of the formed trench is relatively wide, for example, the width can be larger than the width of the trench in the prior art, the insulation between the different active regions of the fins (e.g., between the active region of an n-type fin and another active region of another n-type type fin, between the active region of a p-type fin and the active region of another p-type fin, or the active region of an n-type fin and the active region of a p-type fin) can be increased, thereby improving the insulation between different devices and reducing the interference between the devices.

In one embodiment, in the case where the trench width is widened, dummy gate structures may be formed using conventional processes (e.g., conventional deposition, photolithography, and etching steps), so that the dummy gate structures can be formed on the second insulator layer on the side surfaces of the fins. This eliminates the need to redesign process parameters in forming the dummy gate structures, simplifies the manufacturing processes, and does not require an increase of the overall area of the device structure having multiple devices.

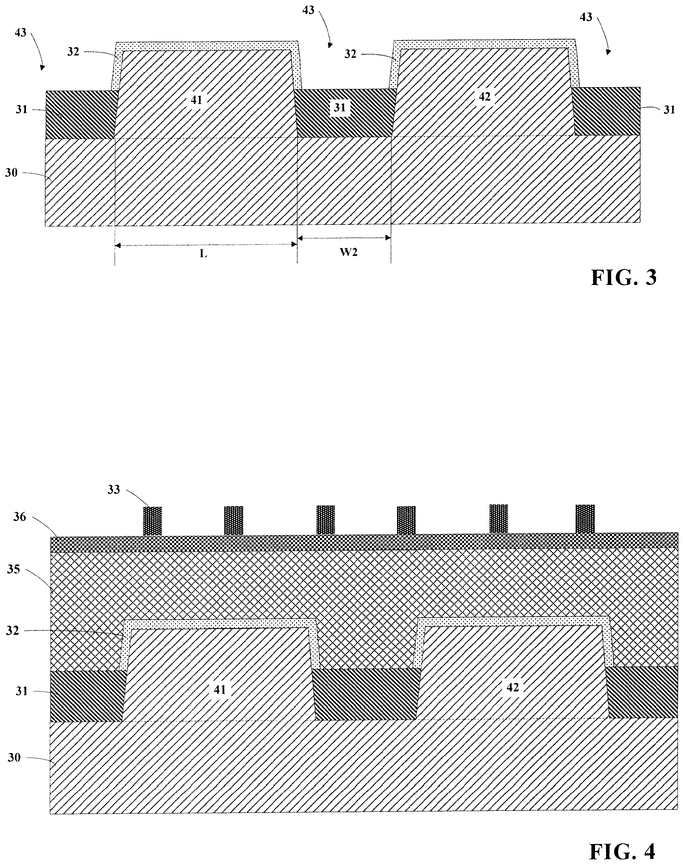

FIGS. 3 through 12 are cross-sectional views of intermediate stages of a structure in the method of manufacturing a semiconductor device according to embodiments of the present invention. The manufacturing process of a semiconductor according to some embodiments of the present invention will be described in detail below with reference to FIGS. 3 to 12.

Referring to FIG. 3, a semiconductor structure is provided. For example, the semiconductor structure may include a semiconductor substrate (e.g., silicon substrate) 30. The semiconductor structure may also include one or more fins (e.g., silicon fins) protruding from semiconductor substrate 30. As shown in FIG. 3, the one or more fins include a first fin 41 and a second fin 42. A trench 43 is disposed on opposite sides of the fins. The semiconductor structure may further include a first insulator layer 31 partially filling trench 43. The fins (e.g., first fin 41, second fin 42) protrude from first insulator layer 31. The semiconductor structure may also include a second insulator layer 32 covering the fins.

In one embodiment, the ratio of the width W2 of the trench to the longitudinal length L of a fin may be in the range between 0.5 and 0.7, e.g., the ratio may be 0.6.

In one embodiment, the width W2 of the trench may be in the range between 80 nm and 130 nm, e.g., 100 nm, or 120 nm.

It is noted that the dotted line in FIG. 3 is for the purpose of clearly showing the different structural portions of the semiconductor structure. The dotted line is thus a virtual line for distinguishing different portions of the semiconductor structure and does not exist in the actual semiconductor structure. Similarly, the dotted lines shown in other drawings are also virtual lines.

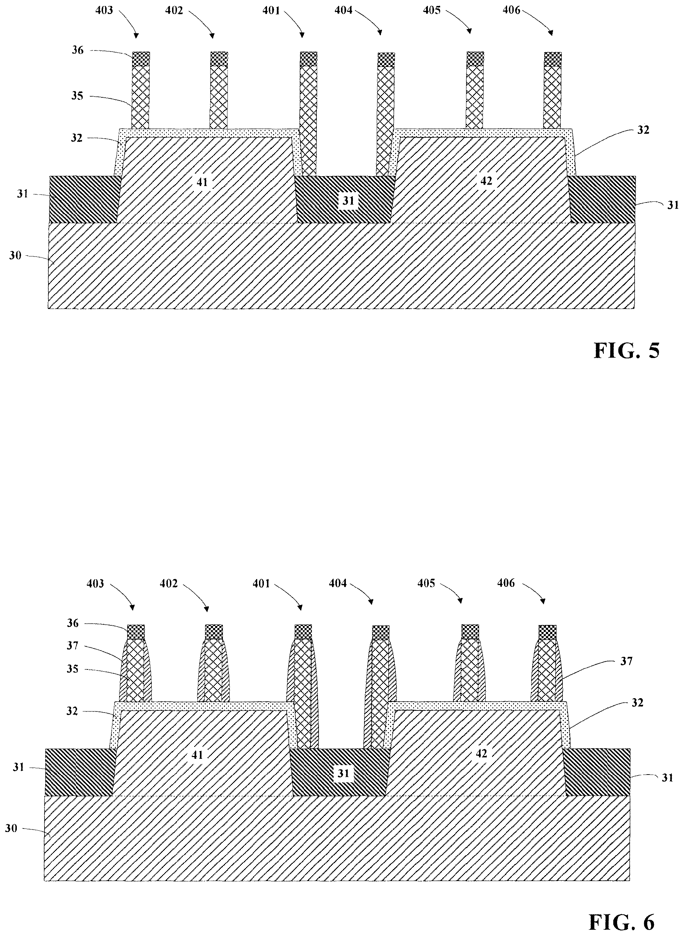

Next, the process of forming a plurality of dummy gate structures for the fins will be described in reference to FIGS. 4 and 5.

Referring to FIG. 4, a dummy gate material layer (e.g., polysilicon) 35 is formed, e.g., using a deposition process, on the semiconductor structure. A hardmask layer (e.g., silicon nitride) 36 is formed, e.g., using a deposition process, on dummy gate material layer 35. A patterned first mask layer (e.g., photoresist) 33 is formed, e.g., using a coating and photolithography process, on hardmask layer 36. Thereafter, an etch process is performed on hardmask layer 36 and dummy gate material layer 35 using patterned first mask layer 33 as a mask, and first mask layer 33 is then removed to obtain the structure as shown in FIG. 5.

Referring to FIG. 5, the plurality of dummy gate structures may include a first dummy gate structure 401 on first insulator layer 31 and a second dummy gate structure 402 on second insulator layer 32. First dummy gate structure 401 and second dummy gate structure 402 are spaced apart from each other. First dummy gate structure 401 is adjacent to a portion of second insulator layer 32 on a side surface of the fin. For example, the dummy gate structure may include a dummy gate 35 on first insulator layer 31 or on second insulator layer 32, and a hardmask layer 36 on dummy gate 35.

In one embodiment, referring to FIG. 5, in the process of forming the plurality of dummy gate structures, the dummy gate structures may also include a third dummy gate structure 403 that is spaced apart from second dummy gate structure 402. First dummy gate structure 401 and third dummy gate structure 403 are disposed on opposite sides of second dummy gate 402. Referring to FIG. 5, third dummy gate structure 403 is disposed at the distal end of the fin (e.g., first fin 41) on a portion of second insulator layer 32.

In one embodiment, the one or more fins may include a first fin 41 and second fin 42 separated by the trench. Referring to FIG. 5, in the process of forming the plurality of dummy gate structures, first dummy gate structure 401, second dummy gate structure 402, and third dummy gate structure 403 are for first fin 41. In one embodiment, referring to FIG. 5, the plurality of dummy gate structures may also include fourth dummy gate structure 404, fifth dummy gate structure 405, and sixth dummy gate structure 406 that are for second fin 42. Fourth dummy gate structure 404 and sixth dummy gate structure 406 are disposed on opposite sides of fifth dummy gate structure 405.

In one embodiment, referring still to FIG. 5, first dummy gate structure 401 is disposed on first insulator layer 31 in the trench between first fin 41 and second fin 42 and abuts a portion of the second insulator layer on a side surface of first fin 41. In one embodiment,, fourth dummy gate structure 404 is disposed on first insulator layer 31 in the trench between first fin 41 and second fin 42 and abuts a portion of the second insulator layer on a side surface of second fin 42. First dummy gate structure 401 and fourth dummy gate structure 404 are spaced apart from each other.

In one embodiment, referring still to FIG. 5, sixth dummy gate structure 406 is disposed at a distal end of second fin 42 (i.e., a distal end of the second fin on the other side of the fifth dummy gate structure opposite the fourth dummy gate structure) on second insulator layer 32. In another embodiment, the sixth dummy gate structure may be disposed on the first insulator layer in a respective trench, and abuts (i.e., adjacent) a portion of the second insulator layer on a side surface of the second fin.

Next, referring to FIG. 6, a spacer is formed on side surfaces of the dummy gate structures.

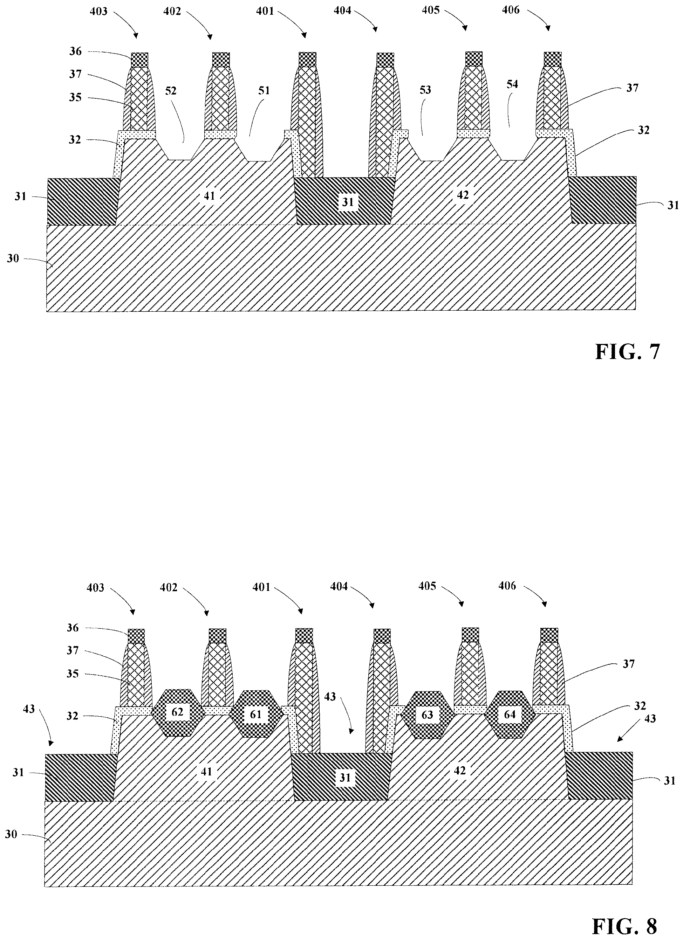

Next, referring to FIG. 7, an etch process is performed on a portion of the second insulator layer and a portion of the fin that are not covered by the spacer and the dummy gate structures to form a recess. In an example embodiment, the etch process may remove a portion of the fins (e.g., first fin 41) to form a first recess 51 between first dummy gate structure 401 and second dummy gate structure 402 and a second recess 52 between second dummy gate structure 402 and third dummy gate structure 403. In another example embodiment, the etch process may remove a portion of the fins (e.g., second fin 42) to form a third recess 53 between fourth dummy gate structure 404 and fifth dummy gate structure 405 and a fourth recess 54 between fifth dummy gate structure 405 and sixth dummy gate structure 406.

Next, referring to FIG. 8, a source layer and a drain layer are formed in the recess using, e.g., an epitaxial growth process. In an example embodiment, a source layer (also referred to as a first source) 61 is formed in first recess 51, and a drain layer (also referred to as a first drain) 62 is formed in second recess 52. In another example embodiment, a source layer (also referred to as a second source) 63 is formed in third recess 53, and a drain layer (also referred to as a second drain) 64 is formed in fourth recess 54.

Thus, a method for manufacturing a semiconductor device according to an embodiment of the present invention is provided. The method enables a widening of the trench so that dummy gate structures can be formed on the first insulator layer in the trench adjacent to (i.e., abutting) side surfaces of the fins. The method can thus improve the insulation between the active regions of the different fins. In other words, the insulation between the different devices can be improved, thereby reducing the interference between the different devices.

FIG. 13 is a cross-sectional view illustrating a stage of a structure in the manufacturing method of a semiconductor device according to another embodiment of the present invention. In the embodiment, referring to FIG. 13, third dummy gate structure 403 may also be disposed on first insulator layer 31 and adjacent to a portion of the second insulator layer on a side surface of the fin (e.g., first fin 41). In the embodiment, the other steps are the same as or similar to those steps described above, with the exception that the location of the third dummy gate structure shown in FIG. 13 differs from the location of that shown in FIG. 8.

FIG. 14 is a cross-sectional view illustrating a stage of a structure in the manufacturing method of a semiconductor device according to yet another embodiment of the present invention. In one embodiment, referring to FIG. 14, first dummy gate structure 401 may be disposed on first insulator layer 31 in the trench between first fin 41 and second fin 42 and adjacent to a portion of the second insulator layer on a side surface of first fin 41. In another embodiment, fourth dummy gate structure 404 may be disposed at a distal end of second fin 42 on a portion of second insulator layer 42. First dummy gate structure 401 and fourth dummy gate structure 404 are spaced apart from each other. In the embodiment, the other steps are the same as or similar to those steps described above, with the exception that the location of the fourth dummy gate structure shown in FIG. 14 differs from the location of that shown in FIG. 8.

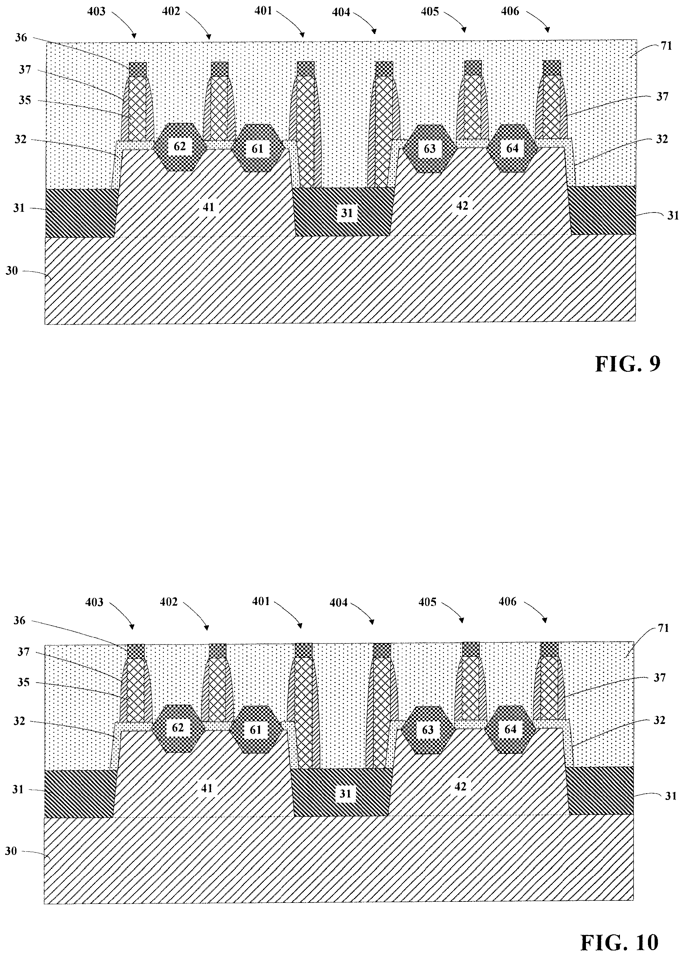

In some embodiments, referring to FIG. 9, the method may further include forming an interlayer dielectric layer (e.g., silicon oxide) 71 covering the semiconductor structure having the source or drain formed thereon.

Next, referring to FIG. 10, a planarization (e.g., chemical mechanical polishing) process is performed on interlayer dielectric layer 71 to expose an upper surface of hardmask layer 36.

Next, referring to FIG. 11, hardmask layer 36, dummy gate 35, and a portion of second insulator layer 32 are removed to form openings, e.g., openings 801, 802, 803, 804, 805, and 806.

Next, referring to FIG. 12, a gate structure 90 is formed in the openings. Gate structure 90 may include a gate insulator layer 901 on the fin and a gate 902 on gate insulator layer 901. Gate insulator layer 901 may include silicon dioxide. Gate 902 may include a metal material, e.g., tungsten.

Thus, embodiments of the present invention provide another method for manufacturing a semiconductor device. According to the described method in the present invention, the dummy gate is replaced with an actual metal gate.

Embodiments of the present invention also provide a semiconductor device. Referring to FIG. 8, the semiconductor device may include a semiconductor substrate (silicon substrate) 30. The semiconductor device may also include one or more fins (e.g., first fin 41 and second fin 42 separated by a trench), and a trench 43 on opposite sides of each fin. In one embodiment, the ratio of the width of the trench to the longitudinal length of the fin is in the range between 0.5 and 0.7, e.g., 0.6. In one embodiment, the width of the trench is in the range between 80 nm and 130 nm, e.g., 100 nm, or 120 nm.

Referring to FIG. 8, the semiconductor device may further include a first insulator material (e.g., silicon dioxide) 31 partially filling trench 43. The fins protrude from the insulator layer. The semiconductor device may also include a second insulator layer (e.g., silicon dioxide) on the fins.

Referring still to FIG. 8, the semiconductor device may also include a plurality of dummy gate structures for the fins. The dummy gate structures may include at least a first dummy gate structure 401 on first insulator layer 31 and a second dummy gate structure 402 on second insulator layer 32. First dummy gate structure 401 and second dummy gate structure 402 are spaced apart from each other. First dummy gate structure 401 abuts (is adjacent to) a portion of the second insulator layer on a side surface of the fin. For example, the dummy gate structure may include a dummy gate 35 disposed on first insulator layer 31 or on second insulator layer 32, and a hardmask layer 36 on dummy gate 35.

In one embodiment, the dummy gate structures may further include a third dummy gate structure 403 spaced apart from second dummy gate structure 402. First dummy gate structure 401 and third dummy gate structure 403 are disposed on opposite sides of second dummy gate structure 402. In one embodiment, referring to FIG. 8, third dummy gate structure 403 is disposed on a portion of the second insulator layer at a distal end of the fin. In another embodiment, referring to FIG. 13, third dummy gate structure 403 is disposed on first insulator layer 31 and abuts (is adjacent to) a portion of the second insulator layer on a side surface of the fin. For example, third dummy gate structure 403 abuts (is adjacent to) a portion of the second insulator layer on a side surface of first fin 41 that is opposite first dummy gate structure 401.

In one embodiment, in the dummy gate structures, first dummy gate structure 401, second dummy gate structure 402, and third dummy gate structure 403 are used for first fin 41. Referring to FIG. 8 or FIG. 14, the dummy gate structures may also include fourth dummy gate structure 404, fifth dummy gate structure 405, and sixth dummy gate structure 406 used for second fin 42. Fourth dummy gate structure 404 and fifth dummy gate structure 405 are disposed on opposite sides of sixth dummy gate structure 406.

In one embodiment, referring to FIG. 8, first dummy gate structure 401 is disposed on first insulator layer 31 in the trench between first fin 41 and second fin 42 and adjacent to a portion of the second insulator layer on a side surface of first fin 41. In one embodiment, still referring to FIG. 8, fourth dummy gate structure 404 is disposed on first insulator layer 31 in the trench between first fin 41 and second fin 42 and adjacent to a portion of the second insulator layer on a side surface of second fin 42. First dummy gate structure 401 and fourth dummy gate structure 404 are spaced apart from each other.

In another embodiment, referring to FIG. 14, first dummy gate structure 401 is disposed on first insulator layer 31 in the trench between first fin 41 and second fin 42 and adjacent to a portion of the second insulator layer on a side surface of first fin 41. In another embodiment, still referring to FIG. 14, fourth dummy gate structure 404 is disposed on a portion of the second insulator layer on a distal end of second fin 42. First dummy gate structure 401 and fourth dummy gate structure 404 are spaced apart from each other. Referring to FIG. 14, the width W3 of the trench between first fin 41 and second fin 42 is the sum of the lateral dimension of the dummy gate structure and the width of the trench in the prior art.

Referring to FIG. 8, the semiconductor device may further include a spacer 37 on the side surface of the dummy gate structures. The spacer may include, e.g., silicon dioxide and/or silicon nitride.

Referring still to FIG. 8, the semiconductor device may further include a source or a drain disposed between the dummy gate structures on the fins. In one exemplary embodiment, the semiconductor device may include a source (also referred to as a first source) 61 between first dummy gate structure 401 and second dummy gate structure 402 on first fin 41, and a drain (also referred to as a first drain) 62 between second dummy gate structure 402 and third dummy gate structure 403 on first fin 41. In another exemplary embodiment, the semiconductor device may include a source (also referred to as a second source) 63 between fourth dummy gate structure 404 and fifth dummy gate structure 405 on second fin 42, and a drain (also referred to as a second drain) 64 between fifth dummy gate structure 405 and sixth dummy gate structure 406 on second fin 42.

According to some embodiments of the present invention, the trench of the semiconductor device is wider than that of the prior art, so that dummy gate structures can be disposed on the first insulator layer in the trench and adjacent to side surfaces of the fins. Embodiments of the present invention can improve the insulation between the active regions of different fins, thereby improving the insulation between the different devices and reducing interference between the devices.

Thus, embodiments of the present invention provide a detailed description of various methods of manufacturing a semiconductor device. Details of well-known processes are omitted in order not to obscure the concepts presented herein.

## Claims

1. A method for manufacturing a semiconductor device, the method comprising:
providing a semiconductor structure including a semiconductor substrate, one or more fins protruding from the semiconductor substrate, a trench on opposite sides of the one or more fins, a first insulator layer partially filling the trench, and a second insulator layer on the one or more fins, the one or more fins protruding from the first insulator layer;
forming a plurality of dummy gate structures associated with the one or more fins, the plurality of dummy gate structures including at least a first dummy gate structure on the first insulator layer and a second dummy gate structure on the second insulator layer, the first and second dummy gate structures being spaced apart from each other, the first dummy gate structure adjacent to a portion of the second insulator layer on a side surface of the one or more fins;
forming a spacer on side surfaces of the dummy gate structures;
etching a portion of the second insulator layer and a portion of the one or more fins not covered by the spacer and the plurality of dummy gate structures to form a recess; and
forming a source or a drain in the recess.

2. The method of claim 1, wherein
a ratio of a width of the trench to a longitudinal length of the one or more fins is in the range between 0.5 and 0.7; and/or
the trench has a width in the range between 80 nm and 130 nm.

3. The method of claim 1 or 2, wherein
the plurality of dummy gate structures further comprise a third dummy gate structure spaced apart from the second dummy gate structure, the first and third dummy gate structures being disposed on opposite sides of the second dummy gate structure, and
the third dummy gate structure disposed on a portion of the second insulator layer on a distal end of the one or more fins, or the third dummy gate structure disposed on the first insulator layer and adjacent to a portion of the second insulator layer on a side surface of the one or more fins; and
wherein preferably: the recess comprises a first recess between the first dummy gate structure and the second dummy gate structure, and a second recess between the second dummy gate structure and the third dummy gate structure, wherein the method further comprises forming the source in the first recess and the drain in the second recess.

4. The method of claim 3, wherein:
the one or more fins comprise a first fin and a second fin spaced apart from each other by the trench;
the first, second, and third dummy gate structures being associated with the first fin;
the plurality of dummy gate structures further comprise:
fourth, fifth, and sixth dummy gate structures associated with the second fin, wherein the fourth and sixth dummy gate structures are disposed on opposite sides of the fifth dummy gate structure.

5. The method of claim 4, wherein:
the first dummy gate structure is disposed on the first insulator layer in the trench between the first fin and the second fin and adjacent to a portion of the second insulator layer on a side surface of the first fin;
the fourth dummy gate structure is disposed on the first insulator layer in the trench between the first fin and the second fin and adjacent to a portion of the second insulator layer on a side surface of the second fin, or, alternatively, the fourth dummy gate structure is disposed on a portion of the second insulator layer on a distal end of the second fin;
the first and fourth dummy gate structures are spaced apart from each other.

6. The method of anyone of the claims 1-5, wherein the dummy gate structures each comprise:
a dummy gate on the first insulator layer or on the second insulator layer; and
a hardmask layer on the dummy gate.

7. The method of claim 6, further comprising:
forming an interlayer dielectric layer on the semiconductor structure after forming the source or the drain;
planarizing the interlayer dielectric layer to expose an upper surface of the hardmask layer;
removing the hardmask layer, the dummy gate structures, and a portion of the second insulator layer to form an opening; and
forming a gate structure in the opening, the gate structure including a gate insulator layer on the one or more fins and a gate on the gate insulator layer.

8. A semiconductor device, comprising:
a semiconductor substrate;
one or more fins protruding from the semiconductor substrate;
a trench on opposite sides of the one or more fins;
a first insulator layer partially filling the trench, the one or more fins protruding from the first insulator layer;
a second insulator layer on the one or more fins;
a plurality of dummy gate structures associated with the one or more fins and including at least a first dummy gate structure on the first insulator layer and a second dummy gate structure on the second insulator layer, the first and second dummy gate structures spaced apart from each other, the first dummy gate structure adjacent to a portion of the second insulator layer on a side surface of the one or more fins;
a spacer on side surfaces of the dummy gate structures; and
a source or drain in the one or more fins and between the dummy gate structures.

9. The semiconductor device of claim 8, wherein
a ratio of a width of the trench to a longitudinal length of the one or more fins is in the range between 0.5 and 0.7; and/or
the trench has a width in the range between 80 nm and 130 nm.

10. The semiconductor device of claim 8 or 9, wherein the plurality of dummy gate structures further comprise a third dummy gate structure spaced apart from the second dummy gate structure, the first and third dummy gate structures being disposed on opposite sides of the second dummy gate structure, and
the third dummy gate structure disposed on a portion of the second insulator layer on a distal end of the one or more fins, or the third dummy gate structure disposed on the first insulator layer and adjacent to a portion of the second insulator layer on a side surface of the one or more fins.

11. The semiconductor device of claim 10, wherein:
the one or more fins comprises a first fin and a second fin spaced apart from each other by the trench;
the first, second, and third dummy gate structures being associated with the first fin;
the plurality of dummy gate structures further comprise:
fourth, fifth, and sixth dummy gate structures associated with the second fin, the fourth and sixth dummy gate structures disposed on opposite sides of the fifth dummy gate structure.

12. The semiconductor device of claim 11, wherein:
the first dummy gate structure is disposed on the first insulator layer in the trench between the first fin and the second fin and adjacent to a portion of the second insulator layer on a side surface of the first fin;
the fourth dummy gate structure is disposed on the first insulator layer in the trench between the first fin and the second fin and adjacent to a portion of the second insulator layer on a side surface of the second fin;
the first and fourth dummy gate structures are spaced apart from each other.

13. The semiconductor device of claim 11 or 12, wherein:
the first dummy gate structure is disposed on the first insulator layer in the trench between the first fin and the second fin and adjacent to a portion of the second insulator layer on a side surface of the first fin;
the fourth dummy gate structure is disposed on a portion of the second insulator layer on a distal end of the second fin;
the first and fourth dummy gate structures are spaced apart from each other.

14. The semiconductor device of anyone of the claims 8-13, wherein the dummy gate structures each comprise:
a dummy gate on the first insulator layer or on the second insulator layer; and
a hardmask layer on the dummy gate.

15. The semiconductor device of anyone of the claims 8-14, further comprising a recess in the one or more fins between the plurality of dummy gate structures, wherein the source or drain is disposed in the recess.
